# EUROPEAN PATENT SPECIFICATION

(11) **EP 3 933 899 B1**
(45) Date of publication and mention of the grant of the patent: **10.05.2023**
(21) Application number: 21761907.1
(22) Date of filing: 09.02.2021
(51) Int. Cl.: H01L 21/66, G06F 17/00, G06F 16/178, G06F 16/17

(54) **MACHINE FILE PROCESSING METHOD AND SYSTEM**
VERFAHREN UND SYSTEM ZUR VERARBEITUNG VON MASCHINENDATEN
PROCÉDÉ ET SYSTÈME DE TRAITEMENT DE FICHIER DE MACHINE

(30) Priority: 24.02.2020 CN 202010113609
(43) Date of publication of application: 05.01.2022
(73) Proprietor: Changxin Memory Technologies, Inc., Hefei, Anhui 230000 (CN)
(72) Inventor: ZHANG, Hui, Anhui 230000 (CN); GAO, Hanxu, Anhui 230000 (CN)
(74) Representative: Lavoix
(86) International application number: PCT/CN2021/076330
(87) International publication number: WO 2021/169808

(56) References cited:
- EP-A2- 2 009 586
- WO-A1-2007/052959
- CN-A- 102 111 428
- CN-A- 103 793 437
- CN-A- 104 851 821
- JP-A- 2008 276 723
- KR-A- 20190 020 491
- US-A1- 2019 249 330

## Description

### TECHNICAL FIELD

The present disclosure relates to a machine station file processing method and a machine station file processing system.

### BACKGROUND

As the demand for chips from terminal devices such as mobile phones and computers continues to increase, in the field of semiconductors, manufacturing devices and testing devices for chips are further upgraded, which correspondingly shortens the chip production and test periods. Therefore, in order to acquire the test results of wafers and chips faster and more intuitively, higher requirements for the processing speed and accuracy of the test files produced by the machine station have been proposed.

In the prior art, the commonly used test file processing method in the industry is to manually export the test files out of the machine station and then generate relevant analysis data of wafers by EXCEL macros.

D1 (KR20190020491 A) discloses a method for monitoring an integrated state of ground station systems, the method comprising: receiving a log file generated by a process of the ground station system; converting the filtered log file into a standardized data format; and transmitting the converted log file to a log file collection device.

### SUMMARY

According to various embodiments, the present disclosure provides a machine station file processing method, applied to an edge computing server, comprising:
monitoring operation of a file system of a machine station server and acquiring a transaction file generated by the operation, the transaction file comprising transaction data;
converting a format of the transaction data according to preset warehousing rules to generate model-layer data; and
sending, to a data warehouse server, the model-layer data and a data analysis request, the data analysis request is used to instruct the data warehouse server to acquire application-layer data according to the model-layer data;
wherein, the preset warehousing rules are rules that have been set for the machine station server, and comprise conditions and methods for format conversion of the transaction data.

According to various embodiments, the present disclosure further provides a machine station file processing method, applied to a machine station file processing system comprising a data warehouse server, the machine station file processing method comprises:
controlling the data warehouse server to:
receive model- layer data and a data analysis request sent by an edge computing server; and
acquire a data field required to be output and convert a format of the model- layer data according to the data field to generate application- layer data, the application-layer data being used to generate a visual page;
wherein, the model-layer data is generated by converting a format of transaction data according to preset warehousing rules, and the preset warehousing rules are rules that have been set for a machine station server, and comprise conditions and methods for format conversion of the transaction data.

According to various embodiments, the present disclosure further provides a machine station file processing system, comprising:
an edge computing server, configured to monitor operation of a file system of a machine station server and acquire a transaction file generated by the operation; convert a format of the transaction data according to preset warehousing rules, to generate model- layer data; and send, to a data warehouse server, the model- layer data and a data analysis request, the data analysis request is used to instruct the data warehouse server to acquire application- layer data according to the model- layer data; and
a data warehouse server, configured to receive the model-level data and the data analysis request sent by an edge computing server; and acquire a data field required to be output and convert the format of the model- layer data according to the data field to generate the application- layer data;
wherein, the preset warehousing rules are rules that have been set for the machine station server, and comprise conditions and methods for format conversion of the transaction data.

The details of one or more embodiments of the present disclosure are set forth in the following drawings and description. Other features and advantages of the present disclosure will become apparent from the description, drawings and claims.

### BRIEF DESCRIPTION OF THE DRAWINGS

In order to explain technical solutions of embodiments of the present disclosure or in the prior art more clearly, the drawings to be used for describing the embodiments or the prior art will be introduced simply. Apparently, the drawings to be described below are merely some embodiments of the present disclosure, and a person of ordinary skill in the art may further obtain other drawings according to these drawings without paying any creative effort.
FIG. 1 is a flowchart of a machine station file processing method in an embodiment;
FIG. 2 is a screenshot of transaction data in an embodiment;
FIG. 3 is a screenshot of model-layer data in an embodiment;
FIG. 4 is a screenshot of application-layer data in an embodiment;
FIG. 5 is a sub-flowchart of S100 in an embodiment;
FIG. 6 is a sub-flowchart of S200 in an embodiment;
FIG. 7 is a sub-flowchart of S230 to S240 in an embodiment;
FIG. 8 is a sub-flowchart of S200 in another embodiment;
FIG. 9 is a flowchart of a machine station file processing method in another embodiment;
FIG. 10 is a visual page of a wafer map in an embodiment;
FIG. 11 is a flowchart of a machine station file processing method in still another embodiment;
FIG. 12 is a flowchart of a machine station file processing method in yet another embodiment;
FIG. 13 is a schematic structure diagram of a machine station file processing system in an embodiment;
FIG. 14 is a schematic structure diagram of a machine station file processing system in another embodiment; and
FIG. 15 is a schematic structure diagram of an edge computing server in an embodiment.

### DESCRIPTION OF THE EMBODIMENTS

Data can be generated by manual operation. However, on one hand, by manually exporting, the newly generated test files cannot be acquired in time, and the files are exported slowly; and on the other hand, when data is manually processed, different EXCEL macros may be needed for different machines station, and only one file can be processed at a time. Therefore, the present processing method cannot meet the industry's demand for the timeliness of machine station file processing.

In order to facilitate the understanding of the present disclosure, the present disclosure will be described more fully below with reference to the relevant drawings. Preferred embodiments of the present disclosure are shown in the drawings. However, the present disclosure may be implemented in many different forms and is not limited to the embodiments described herein. On the contrary, these embodiments are provided to make the disclosure of the present disclosure more thorough and comprehensive.

Unless otherwise defined, all technical and scientific terms used herein have the same meaning as commonly understood by a person of ordinary skill in the art to which the present disclosure belongs. Here, terms used in the description of the present disclosure are merely intended to describe specific embodiments, rather than limiting the present disclosure. As used herein, the term "and/or" includes any or all of one or more associated listed items or combinations thereof.

In the description of the present disclosure, it should be understood that orientations or positional relationships indicated by terms such as "upper", "lower", "vertical", "horizontal", "inner", "outer" are the orientations and the positional relationships illustrated on the basis of the drawings, and used just for convenience of describing the present disclosure and simplifying the description, rather than indicating or implying that the devices or elements must have a specific orientation and be constructed and operated in the specific orientation, and therefore shall not be considered as any limitations to the present disclosure.

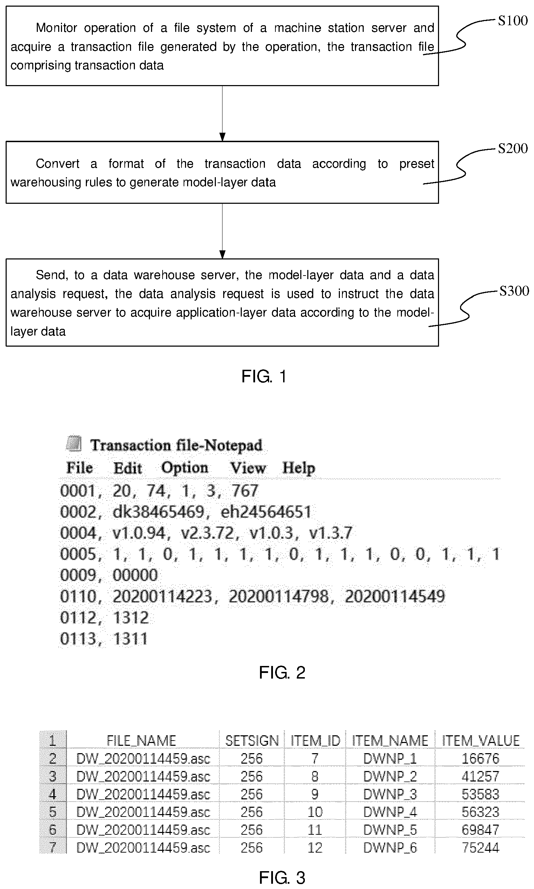

FIG. 1 is a flowchart of a machine station file processing method in an embodiment. The machine station file processing method in this embodiment is applied to an edge computing server. As shown in FIG. 1, the machine station file processing method in this embodiment comprises S100 to S300.

S100: The operation of a file system of a machine server is monitored and a transaction file generated by the operation is acquired, the transaction file comprising transaction data.

Wherein, the machine station server comprises a WP machine station server, a TM machine station server, etc. Different machine stations are used to acquire test data at different stages of wafer process or in different characterization methods. The different characterization methods comprise optical tests, electrical tests, etc. The addition, modification, and deletion of files are all operations of the file system, but only the addition and modification operations will generate transaction files. Therefore, the machine station file processing method in this embodiment focuses on only the addition and modification operations. The transaction data is the data saved in the transaction files.

Specifically, when the machine station server tests a new wafer, an added transaction file will be generated; and when the machine station server repeats the test on the tested wafer, a modified transaction file will be generated. The generation of transaction files must be accompanied by corresponding operations. Therefore, by monitoring the addition or modification operation of the file system, it may be found that transaction files have been generated on the machine station server. In this way, the transaction files may be sent to the edge computing server in time.

FIG. 2 is a screenshot of transaction data in an embodiment. As shown in FIG. 2, a transaction file usually comprises multiple lines of transaction data. In this embodiment, lines of transaction data contain different data formats and data volumes. It is unable for the operator to know the test result of a wafer only by the transaction file. Therefore, it is necessary to process the data in the transaction file to obtain the intuitive test result.

S200: The format of the transaction data is converted according to preset warehousing rules to generate model-layer data.

Wherein, the preset warehousing rules are rules that have been set in the edge computing server for different machine station servers, and the preset warehousing rules comprise conditions and methods for format conversion of the transaction data. The model-layer data is data that can be directly analyzed.

Specifically, there is difference in the definition of the format, unit, naming, etc., of the transaction files generated by different machine stations. For example, to determine whether the thickness of a set layer of a wafer meets a thickness threshold, some machine stations are recorded in 0 and 1 while the other machine stations are recorded in YES and NO. For another example, to record the width of lines, micrometer is used as the unit in some machine stations while nanometer is used as the unit in the other machine stations. Therefore, it is unable to efficiently analyze the transaction files generated by different machine stations only by a same data analysis method. FIG. 3 is a screenshot of model-layer data in an embodiment. As shown in FIG. 3, the model-layer data is clear in structure, and transaction files generated by different machine stations can be converted into model-layer data with the same definition of the format, unit, naming, etc. Therefore, during data analysis, the test results of different wafer demand parameters may be obtained simply and quickly from the model-layer data according to the needs of data analysis. In this embodiment, unstructured transaction data is converted into structured model-layer data by a format conversion operation, which reduces the complexity of data analysis, thereby improving the efficiency of data analysis.

S300: The model-layer data and a data analysis request are sent to a data warehouse server. The data analysis request is used to instruct the data warehouse server to acquire application-layer data according to the model-layer data.

Wherein, the application-layer data is the data required by the business generated after handling and processing. That is, the application-layer data contains less data, and the data that does not need to be displayed and applied has been eliminated.

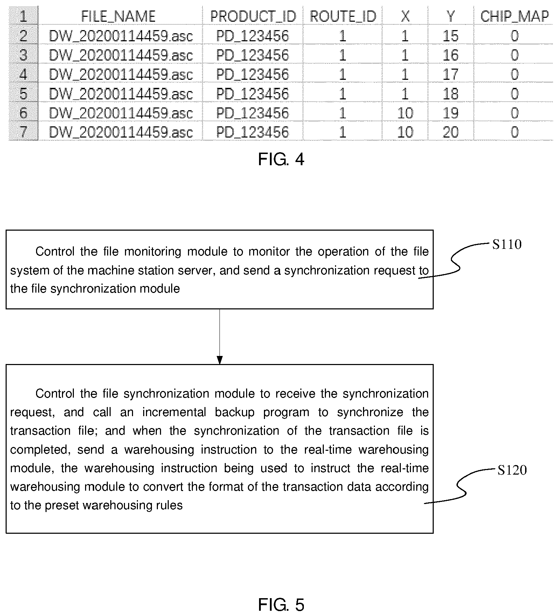

Specifically, the edge computing server synchronously sends the generated model-layer data and the data analysis request to the data warehouse server, and the data warehouse server further filters the model-layer data under the instruction of the data analysis request to retain, in the application-layer data, only the data to be displayed and applied. FIG. 4 is a screenshot of application-layer data in an embodiment. As shown in FIG. 4, the field settings of the application-layer data are the same as the items that need to be displayed and applied. Compared with the model-layer data, the content of the application-layer data is more concise and clear. For example, the fields are PRODUCT_ID (product No.), X and Y, etc. The operator can obtain the test result of the required item by going through the application-layer data.

The machine station file processing method realizes timely acquisition of the added and modified transaction files on the machine station server by monitoring the file system of the machine station server, avoiding low efficiency and easy file omissions when manually exporting data. Moreover, in this embodiment, the transaction files are sent to the edge computing server in an incremental synchronization manner, which improves the efficiency of file synchronization. Further, the edge computing server and the machine station server in this embodiment are both located in the FAB network segment. In this embodiment, data collection and initial processing are directly performed on the data side where the machine station server is located, and then the model-layer data initially processed by the edge computing server is sent to the data warehouse server in the OA network segment in real time, which solves the problems of low transmission speed and delay in processing that are easily caused by the excessive amount of machine station file data. Therefore, compared with the prior art, the machine station file processing method in this embodiment can automatically synchronize and warehouse transaction files and output structured model-layer data, thereby reducing the complexity of data analysis and improving the timeliness and accuracy of machine station file processing.

In an embodiment, the edge computing server comprises a file monitoring module, a file synchronization module, and a real-time warehousing module. FIG. 5 is a sub-flowchart of S100 in this embodiment. As shown in FIG. 5, the step S100 of the machine station file processing method comprises S110 to S120.

S110: The file monitoring module is controlled to monitor the operation of a file system of a machine station server, and send a synchronization request to the file synchronization module.

Wherein, the file monitoring module is configured to monitor the addition and modification operations of the file system of the machine station server, and the file synchronization module is configured to synchronize the transaction files on the machine station server to the edge computing server.

Specifically, when the file monitoring module discovers the addition and modification operations of the file system, the file monitoring module immediately sends a synchronization request to the file synchronization module. The synchronization request is used to instruct the file synchronization module to synchronize the transaction files to the edge computing server for timely synchronization of the transaction files.

In an embodiment, the addition and modification operations of the file system of the machine station server are monitored by Inotify in Linux kernel. Inotify can monitor the set files and can also monitor the set directories or subdirectories, and issue related event warnings to the set programs or modules in time through the kernel. Therefore, in this embodiment, by Inotify, file monitoring that is more flexible, occupies less resource, and is more responsive is realized.

S120: The file synchronization module is controlled to receive the synchronization request, and call an incremental backup program to synchronize the transaction file; and when the synchronization of the transaction file is completed, send a warehousing instruction to the real-time warehousing module, the warehousing instruction being used to instruct the real-time warehousing module to convert the format of the transaction data according to preset warehousing rules.

Wherein, the incremental backup program is used for incremental backup of the transaction files. Incremental backup is a backup method to obtain the differential data between this backup and the previous backup. That is, after the first full backup, when the second incremental backup is performed, only the differential data between the second backup and the first backup is backed up; when the third incremental backup is performed, only the differential data between the third backup and the second backup is backed up; and so on. The real-time warehousing module is configured to warehouse the transaction data synchronized to the edge computing server to generate model-layer data.

Specifically, after the file synchronization module receives the synchronization request, the file synchronization module calls the incremental backup program to synchronize the transaction files. Compared with the full backup and the differential backup, the incremental backup requires less data to be backed up during each time of synchronization and is less time-consuming, and data occupies less space in the edge computing server, which is more suitable for the machine station file processing method in this embodiment. Moreover, the file control module can immediately send the warehousing instruction to the real-time warehousing module when the synchronization is completed. This can warehouse the transaction data in time, and effectively avoid the accumulation of transaction data caused by delay in processing.

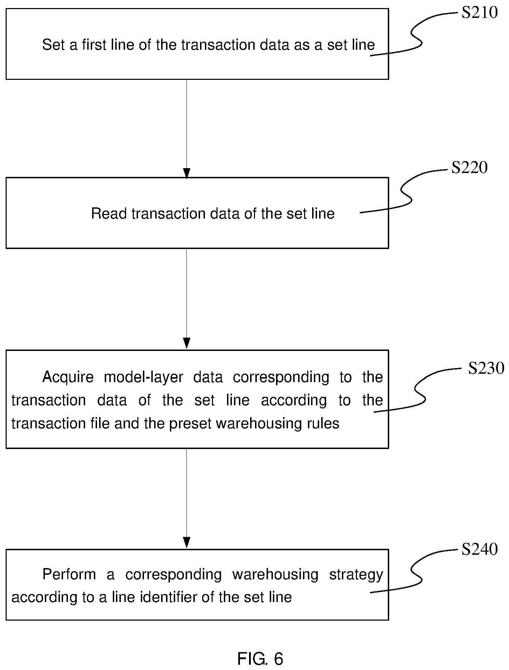

In an embodiment, the transaction file comprises at least one line of transaction data. FIG. 6 is a sub-flowchart of S200 in this embodiment. As shown in FIG. 6, the step S200 of the machine station file processing method comprises S210 to S240.

S210: The first line of the transaction data is set as a set line.

Specifically, since each line of transaction data contain different data formats and data volumes, it is unable to warehouse each line of the data in exactly the same way. Therefore, in this embodiment, set lines are warehoused one by one, by reading in lines. Further, in order to avoid the omission of transaction data, after acquiring the transaction file from a designate directory of the edge computing server, the real-time warehousing module in this embodiment starts reading and conversion from the first line of the transaction data, that is, sets the first line of the transaction data as a set line. For example, the first line in FIG. 2 is the line "0001, 20, 74, 1, 3, 767".

S220: The transaction data of the set line is read.

S230: Model-layer data corresponding to the transaction data of the set line is acquired according to the transaction file and the preset warehousing rules.

Specifically, the preset warehousing rules comprise the conditions and methods for format conversion of the transaction data. Therefore, the content, which meets the format conversion conditions, in the transaction data can be imported into the set output position according to the set format conversion method and in a set output format, so as to acquire the model-layer data corresponding to the transaction data of the set line.

S240: A corresponding warehousing strategy is performed according to a line identifier of the set line.

Specifically, the transaction file usually comprises multiple lines of transaction data, and this embodiment supports warehousing by reading in lines. Therefore, it is necessary to traverse through each line of data in the transaction data by a set method. The warehousing strategy stipulates the logic and sequence of traversing through each line of transaction data. In this embodiment, by performing a corresponding warehousing strategy according to the line identifier, each line of transaction data can be acquired efficiently and completely.

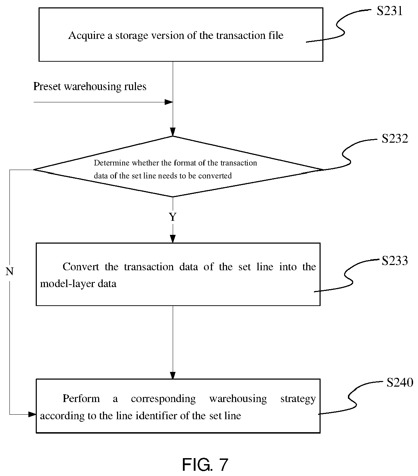

In an embodiment, as shown in FIG. 7, the step S230 of the machine station file processing method comprises S231 to S233.

S231: A storage version of the transaction file is acquired.

Specifically, transaction files of different types have different storage methods, and the storage versions of the transaction files are in one-to-one correspondence to the storage methods. Therefore, the storage methods of the transaction files may be acquired by acquiring their storage versions, so as to accurately warehouse the transaction data. This avoids format errors or content errors during the warehousing.

S232: It is determined, according to the storage version and the preset warehousing rules, whether the format of the transaction data of the set line needs to be converted.

Specifically, the preset warehousing rules have been set in the real-time warehousing module. The preset warehousing rules comprise information such as format conversion conditions and methods. Therefore, whether the format of data of the set line needs to be converted may be determined according to the conditions in the preset warehousing rules.

S233: The transaction data of the set line is converted into model-layer data, if the format of data of the set line needs to be converted.

If the format of data of the set line does not need to be converted, for example, the data of the set line in the transaction data is only used to record the test time of the wafer on the machine station, without involving information such as the wafer No. and test results. It is stipulated in the preset warehousing rules that the test time parameter is not warehoused, so there is no need to convert the transaction data of the set line into model-layer data. The process directly returns to S240 where a corresponding warehousing strategy is performed according to the line identifier of the set line.

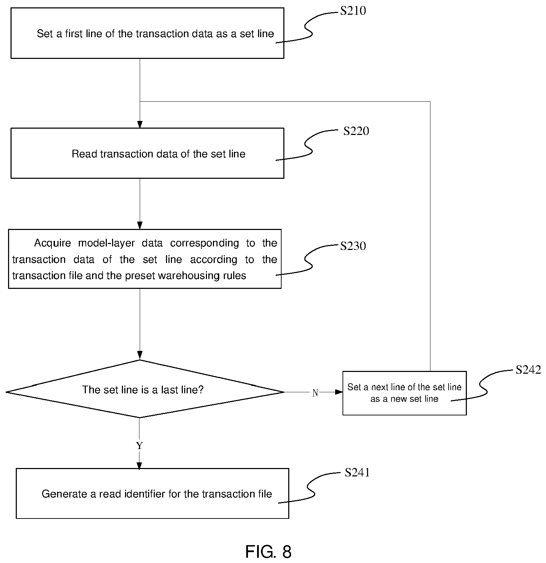

In an embodiment, as shown in FIG. 8, the step S240 of the machine station file processing method comprises S241 to S242.

S241: When the set line is the last line, a read identifier is generated for the transaction file.

Specifically, when the set line is the last line, it is indicated that the transaction data in the transaction file has been all read and warehoused. Then, the process jumps out of the loop of S220 to S230. Further, when the transaction file is successfully read and warehoused, by generating a read identifier for the transaction file, it is possible to prevent the repeated reading of files without any transaction by mistake, thereby improving the reliability of reading the files when they are warehoused in the machine station file processing method.

S242: When the set line is not the last line, the next line of the set line is set as a new set line, and the steps (S220 to S230) of reading the transaction data of the set line and acquiring model-layer data corresponding to the transaction data of the set line according to the transaction file and the preset warehousing rules are repeated until the new set line becomes the last line.

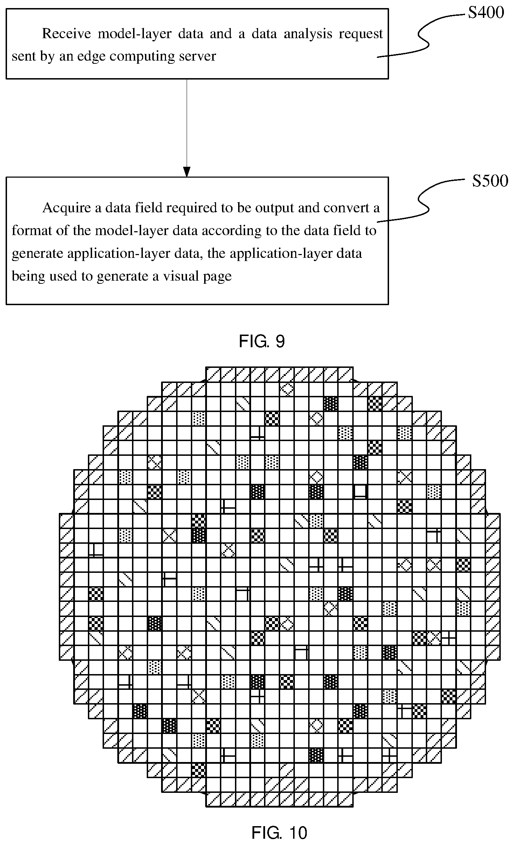

FIG. 9 is a flowchart of a machine station file processing method in an embodiment. The machine station file processing method in this embodiment is applied to a machine station file processing system. The machine station file processing system comprises a data warehouse server. As shown in FIG. 9, the machine station file processing method in this embodiment comprises S400 to S500.

S400: Model-layer data and a data analysis request sent by an edge computing server are received.

Specifically, the data warehouse server receives structured model-layer data, and responds to the data analysis request to acquire application-layer data according to the model-layer data.

S500: A data field required to be output is acquired and the format of the model-layer data is converted according to the data field to generate application-layer data, the application-layer data being used to generate a visual page.

The data fields required to be output are the data fields that need to be displayed and applied, that is, the data fields such as PRODUCT_ID, ROUTE_ID, X, Y, and CHIP_MAP shown in FIG. 4. The visual page is an intuitive graph or image that will be generated based on data. For example, scatter charts, pie charts, histograms, etc., are all visual pages. FIG. 10 shows a visual page of a wafer map commonly used in the field of semiconductors. The wafer map is used to intuitively show the distribution of qualified and defective grains in the wafer. The different filling methods in the wafer map may indicate the process or cause for the generation of defective grains.

Specifically, in this embodiment, the data field required to be output is acquired first, then the data required to be output is filtered from the model-layer data, and finally the application-layer data is acquired according to the filtered data. For example, in this embodiment, it is necessary to output the data in the data field "X", and the test file generated by the machine station comprises the test data in both the field "A" and the field "B". The data in the field "X" needs to be acquired by further analysis of the test data in the field "A" and the field "B". Therefore, in this embodiment, the test data in the field "A" and the field "B" needs to be filtered from the model-layer data first, then the set data analysis is performed to obtain the data in the field "X", and finally the data in the field "X" is saved in the application-layer data. It may be understood that, due to the enormous amount of wafer tests on a machine station, there is still a large amount of test data to be processed even in the stage of acquiring application-layer data. Therefore, in this embodiment, the application-layer data is automatically acquired according to the model-layer data and the data field required to be output. This can greatly reduce the complicated operation of acquiring the application-layer data manually, thereby improving the efficiency and reliability of acquiring the application-layer data.

Further, in this embodiment, in the process of acquiring the application-layer data, test data sheets in multiple different dimensions may be acquired based on the same actual test data, and the test data may be analyzed in multiple dimensions, thereby solving the problem that the analysis is not comprehensive enough since the data cannot be correlated for analysis.

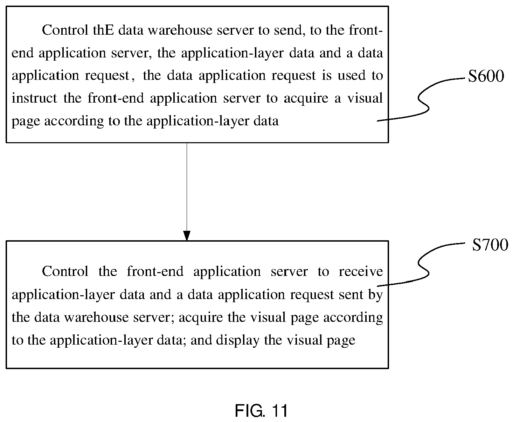

In an embodiment, the machine station file processing system further comprises a front-end application server. FIG. 11 is a flowchart of a machine station file processing method in this embodiment. As shown in FIG. 11, the machine station file processing method in this embodiment further comprises S600 to S700.

S600: The data warehouse server is controlled to send, to a front-end application server, the application-layer data and a data application request that is used to instruct the front-end application server to acquire a visual page according to the application-layer data.

Specifically, by sending the application-layer data and the data application request to the front-end application server, the front-end application server can be instructed to automatically acquire an appropriate visual page according to the application-layer data. Usually in the wafer data application stage, different visual pages need to be output for different data fields, so manual operations require complicated data selection and visual page type selection operations. In this embodiment, by the data application request, the front-end application server is instructed to automatically acquire a visual page, thereby improving the efficiency of data display and application.

S700: The front-end application server is controlled to receive application-layer data and a data application request sent by the data warehouse server; acquire the visual page according to the application-layer data; and display the visual page.

Specifically, the front-end application server receives the application-level data, and responds to the data application request, thereby quickly acquiring and displaying a visual page according to the application-layer data, which improves the speed of data display and application of the machine station file processing method. Wherein, the front-end application server may acquire the visual page by methods such as data analysis tools or front-end code development.

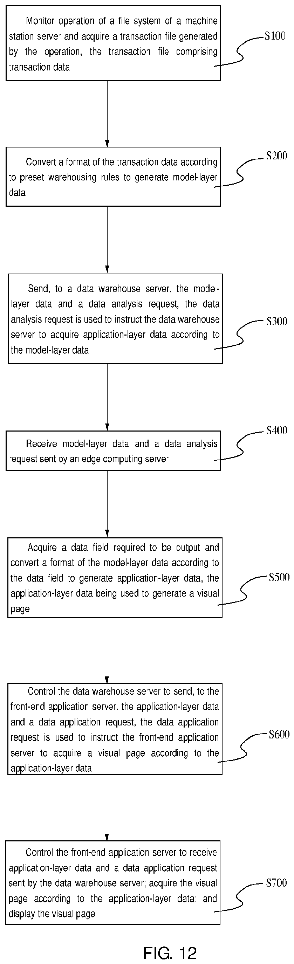

FIG. 12 is a machine station file processing method in an embodiment. As shown in FIG. 12, the machine station file processing method in this embodiment comprises S100 to S700. The machine station file processing method in this embodiment realizes timely acquisition of the added and modified files on the machine station server by monitoring the file system of the machine station server, avoiding low efficiency and easy file omissions when manually exporting data. Moreover, in this embodiment, the transaction files are sent to the edge computing server in an incremental synchronization manner, which improves the efficiency of file synchronization. Further, the edge computing server and the machine station server in this embodiment are both located in the FAB network segment. In this embodiment, data collection and initial processing are directly performed on the data side where the machine station server is located, and then the model-layer data initially processed by the edge computing server is sent to the data warehouse server in the OA network segment in real time, which solves the problems of low transmission speed and delay in processing that are easily caused by the excessive amount of machine station file data. After the model-layer data is acquired, in this embodiment, the application-layer data is acquired automatically by the data warehouse server, and a visual page is automatically acquired and displayed by the front-end application server. Thus, faster data display and application is realized. Therefore, from test file generation, data collection, data analysis to visual page display, this embodiment realizes a completely automatic data processing process, so the method in this embodiment is a machine station file processing method with both timeliness and reliability.

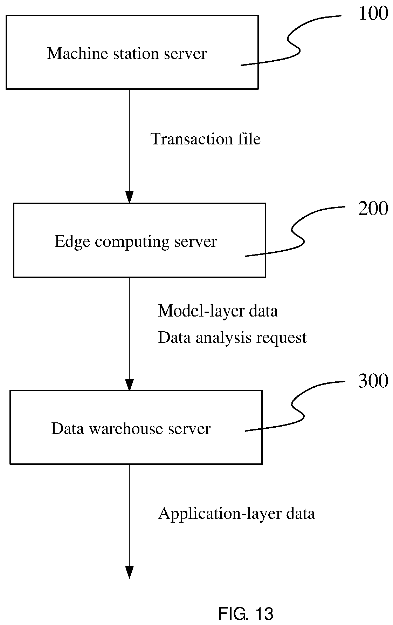

FIG. 13 is a schematic structure diagram of a machine station file processing system in an embodiment. As shown in FIG. 13, the machine station file processing system comprises a machine station server 100, an edge computing server 200, and a data warehouse server 300.

The machine station server 100 is configured to perform file system operations and generate a transaction file.

The edge computing server 200 is configured to: monitor the operation of the file system of the machine station server 100 and acquire a transaction file generated by the operation; the edge computing server convert the format of the transaction data according to preset warehousing rules to generate model-layer data; and send, to the data warehouse server 300, the model-layer data and a data analysis request that is used to instruct the data warehouse server 300 to acquire application-layer data according to the model-layer data.

The data warehouse server 300 is configured to: receive model-layer data and a data analysis request sent by the edge computing server 200; and acquire a data field required to be output and convert the format of the model-layer data according to the data field to generate application-layer data, the application-layer data being used to generate a visual page.

The machine station file processing system in this embodiment acquires the added and modified transaction files on the machine station server 100 in time by the edge computing server 200, and converts the transaction data into structured model-layer data on the data side, and then converts the model-layer data into application-layer data by the data warehouse server 300, thereby realizing fast acquisition and analysis of test files.

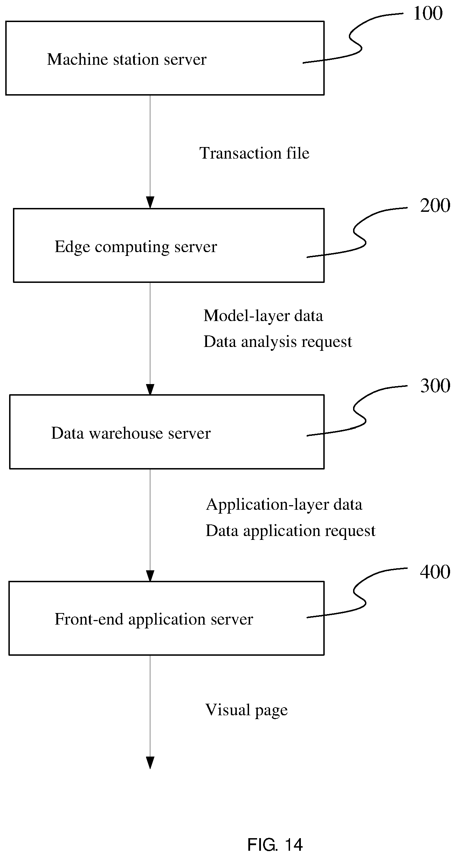

FIG. 14 is a schematic structure diagram of a machine station file processing system in an embodiment. As shown in FIG. 14, the data warehouse server 300 is further configured to send, to the front-end application server 400, the application-layer data and a data application request that is used to instruct the front-end application server 400 to acquire a visual page according to the application-layer data. The machine station file processing system further comprises a front-end application server 400 configured to: receive application-layer data and a data application request sent by the data warehouse server 300; acquire the visual page according to the application-layer data; and display the visual page. The machine station file processing system in this embodiment realizes automatic visualization of test data by the front-end application server 400, thereby improving the efficiency of data display and application.

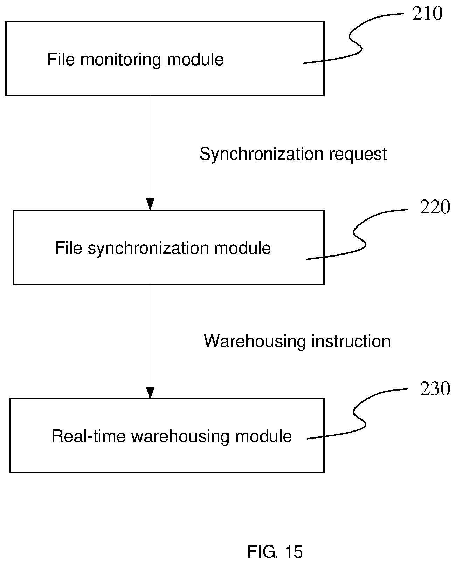

FIG. 15 is a schematic structure diagram of an edge computing server 200 in an embodiment. As shown in FIG. 15, the edge computing server 200 comprises: a file monitoring module 210, a file synchronization module 220 and a real-time warehousing module 230.

The file monitoring module 210 is configured to monitor the operation of a file system of a machine station server 100, and send a synchronization request to the file synchronization module 220.

The file synchronization module 220 is configured to: receive the synchronization request, and call an incremental backup program to synchronize the transaction file; and when the synchronization of the transaction file is completed, send a warehousing instruction to the real-time warehousing module 230, the warehousing instruction being used to instruct the real-time warehousing module 230 to convert the format of the transaction data according to preset warehousing rules.

The real-time warehousing module 230 is configured to: convert the format of the transaction data according to preset warehousing rules to generate model-layer data; and send, to a data warehouse server 300, the model-layer data and a data analysis request that is used to instruct the data warehouse server 300 to acquire application-layer data according to the model-layer data.

Through the cooperation of the file monitoring module 210, the file synchronization module 220 and the real-time warehousing module 230, the edge computing server 200 in this embodiment realizes the automatic incremental synchronization of transaction files and the automatic warehousing of transaction data, thereby effectively avoiding the accumulation of transaction data caused by delay in processing, and thus improving the operational reliability of the machine station file processing system.

Various technical features of the above embodiments can be arbitrarily combined. For simplicity, all possible combinations of various technical features of the above embodiments are not described. However, all those technical features shall be included in the protection scope of the present disclosure if not conflict.

The embodiments described above merely represent certain implementations of the present disclosure. Although those embodiments are described in more specific details, it is not to be construed as any limitation to the scope of the present disclosure. It should be noted that, for a person of ordinary skill in the art, a number of variations and improvements may be made without departing from the concept of the present disclosure, and those variations and improvements should be regarded as falling into the protection scope of the present disclosure. Therefore, the protection scope of the present disclosure should be subject to the appended claims.

## Claims

1. A machine station file processing method, applied to an edge computing server (200), **characterized by** comprising:
monitoring operation of a file system of a machine station server (100) and acquiring a transaction file generated by the operation, the transaction file comprising transaction data (S100);
converting a format of the transaction data according to preset warehousing rules to generate model-layer data (S200); and
sending, to a data warehouse server (300), the model-layer data and a data analysis request, the data analysis request is used to instruct the data warehouse server (300) to acquire application-layer data according to the model-layer data (S300);
wherein, the preset warehousing rules are rules that have been set for the machine station server (100), and comprise conditions and methods for format conversion of the transaction data.

2. The machine station file processing method according to claim 1, wherein the edge computing server (200) comprises a file monitoring module (210), a file synchronization module (220) and a real-time warehousing module (230); and the monitoring operation of a file system of a machine station server (100) and acquiring a transaction file generated by the operation comprises:
controlling the file monitoring module (210) to monitor the operation of the file system of the machine station server (100), and sending a synchronization request to the file synchronization module (220) (S110); and
controlling the file synchronization module (220) to receive the synchronization request, and calling an incremental backup program to synchronize the transaction file; and when the synchronization of the transaction file is completed, sending a warehousing instruction to the real-time warehousing module (230), the warehousing instruction being used to instruct the real-time warehousing module (230) to convert the format of the transaction data according to the preset warehousing rules (S120).

3. The machine station file processing method according to claim 1, wherein
the transaction file comprises at least one line of transaction data; and
the converting a format of the transaction data according to preset warehousing rules to generate model-layer data comprises:
setting a first line of the transaction data as a set line (S210);
reading transaction data of the set line (S220);
acquiring model-layer data corresponding to the transaction data of the set line according to the transaction file and the preset warehousing rules (S230); and
performing a corresponding warehousing strategy according to a line identifier of the set line (S240).

4. The machine station file processing method according to claim 3, wherein the performing a corresponding warehousing strategy according to a line identifier of the set line (S240) comprises:
when the set line is a last line, generating a read identifier for the transaction file(S241); and
when the set line is not the last line, setting a next line of the set line as a new set line (S242), and repeating steps of reading the transaction data of the set line (S220) and acquiring model-layer data corresponding to the transaction data of the set line according to the transaction file and the preset warehousing rules (S230) until the new set line becomes the last line.

5. The machine station file processing method according to claim 3 or 4, wherein the acquiring model-layer data corresponding to the transaction data of the set line according to the transaction file and the preset warehousing rules (S230) comprises:
acquiring a storage version of the transaction file (S231);
determining, according to the storage version and the preset warehousing rules, whether the format of the transaction data of the set line needs to be converted (S232);
converting the transaction data of the set line into the model-layer data (S233), if the format of the transaction data of the set line needs to be converted; and
directly returning to step of performing a corresponding warehousing strategy according to the line identifier of the set line (S240), if the format of the transaction data of the set line does not need to be converted.

6. The machine station file processing method according to claim 1, wherein the monitoring operation of a file system of a machine station server (100) comprises: monitoring addition and modification operations of the file system of the machine station server (100) by Inotify in Linux kernel.

7. The machine station file processing method according to claim 1, wherein the sending, to the data warehouse server (300), the model-layer data and the data analysis request and the data analysis request is used to instruct the data warehouse server (300) to acquire application-layer data according to the model-layer data (S300) comprises:
synchronously sending, by the edge computing server (200), generated model-layer data and the data analysis request to the data warehouse server (300), and further filtering, by the data warehouse server (300), the model-layer data under the instruction of the data analysis request to retain, in the application-layer data, only the data to be displayed and applied.

8. The machine station file processing method according to claim 2, wherein, after acquiring the transaction file from a designate directory of the edge computing server (200), the real-time warehousing module (230) starts reading and conversion from a first line of the transaction data, that is, sets the first line of the transaction data as a set line.

9. A machine station file processing method, applied to a machine station file processing system **characterized by** comprising a data warehouse server (300), the machine station file processing method comprises: controlling the data warehouse server (300) to:
receive model-layer data and a data analysis request sent by an edge computing server (200) (S400); and
acquire a data field required to be output and convert a format of the model-layer data according to the data field to generate application-layer data, the application-layer data being used to generate a visual page (S500);
wherein, the model-layer data is generated by converting a format of transaction data according to preset warehousing rules, and the preset warehousing rules are rules that have been set for a machine station server (100), and comprise conditions and methods for format conversion of the transaction data.

10. The machine station file processing method according to claim 9, wherein the machine station file processing system further comprises a front-end application server (400); and the machine station file processing method further comprises:
controlling the data warehouse server (300) to send, to the front-end application server (400), the application-layer data and a data application request, the data application request is used to instruct the front-end application server (400) to acquire a visual page according to the application-layer data (S600); and
controlling the front-end application server (400) to receive application-layer data and a data application request sent by the data warehouse server (300); acquiring the visual page according to the application-layer data; and displaying the visual page (S700).

11. The machine station file processing method according to claim 9, wherein the data field required to be output is acquired first, then the data required to be output is filtered from the model-layer data, and finally the application-layer data is acquired according to the filtered data.

12. A machine station file processing system, **characterized by** comprising:
an edge computing server (200), configured to monitor operation of a file system of a machine station server (100) and acquire a transaction file generated by the operation(S100); convert a format of the transaction data according to preset warehousing rules, to generate model-layer data (S200); and send, to a data warehouse server (300), the model-layer data and a data analysis request, the data analysis request is used to instruct the data warehouse server (300) to acquire application-layer data according to the model-layer data (S300); and
a data warehouse server (300), configured to receive the model-layer data and the data analysis request sent by an edge computing server (200) (S400); and acquire a data field required to be output and convert the format of the model-layer data according to the data field to generate the application-layer data (S500);
wherein, the preset warehousing rules are rules that have been set for the machine station server (100), and comprise conditions and methods for format conversion of the transaction data.

13. The machine station file processing system according to claim 12, wherein the data warehouse server (300) is further configured to send, to a front-end application server (400), the application-layer data and a data application request, the data application request is used to instruct the front-end application server (400) to acquire a visual page according to the application-layer data; and the machine station file processing system further comprises:
a front-end application server (400), configured to receive the application-layer data and the data application request sent by the data warehouse server (300); acquire a visual page according to the application-layer data; and display the visual page.

14. The machine station file processing system according to claim 12 or 13, wherein the edge computing server (200) comprises:
a file monitoring module (210), configured to monitor the operation of the file system of the machine station server (100), and send a synchronization request to a file synchronization module (220);
the file synchronization module (220), configured to receive the synchronization request, and call an incremental backup program to synchronize a transaction file; and when the synchronization of the transaction file is completed, send a warehousing instruction to a real-time warehousing module (230), the warehousing instruction being used to instruct the real-time warehousing module (230) to convert a format of the transaction data according to preset warehousing rules; and
the real-time warehousing module (230), configured to convert the format of the transaction data according to preset warehousing rules to generate model-layer data (S200); and send, to a data warehouse server (300), the model-layer data and a data analysis request, the data analysis request is used to instruct the data warehouse server (300) to acquire application-layer data according to the model-layer data (S300).

## Patentansprüche

1. Maschinenstation-Dateiverarbeitungsverfahren, das auf einen Edge-Computing-Server (200) angewendet wird, **dadurch gekennzeichnet, dass** es Folgendes umfasst:
Überwachen eines Betriebs eines Dateisystems eines Maschinenstation-Servers (100) und Erfassen einer durch den Betrieb erzeugten Transaktionsdatei, die Transaktionsdatei umfassend Transaktionsdaten (S100);
Konvertieren eines Formats der Transaktionsdaten gemäß voreingestellter Lagerhaltungsregeln, um Modellschicht-Daten zu erzeugen (S200); und
Senden der Modellschicht-Daten und einer Datenanalyseanforderung an einen Datenlager-Server (300), wobei die Datenanalyseanforderung verwendet wird, um den Datenlager-Server (300) anzuweisen, Anwendungsschicht-Daten gemäß den Modellschicht-Daten (S300) zu erfassen;
wobei die voreingestellten Lagerungsregeln Regeln sind, die für den Maschinenstation-Server (100) festgelegt wurden, und Bedingungen und Verfahren zur Formatkonvertierung der Transaktionsdaten umfassen.

2. Maschinenstation-Dateiverarbeitungsverfahren nach Anspruch 1, wobei der Edge-Computing-Server (200) ein Datei-Überwachungsmodul (210), ein Dateisynchronisationsmodul (220) und ein Echtzeit-Lagerungsmodul (230) umfasst; und der Überwachungsvorgang eines Dateisystems eines Maschinenstation-Servers (100) und ein Erfassen einer durch den Vorgang erzeugten Transaktionsdatei Folgendes umfasst:
Steuern des Datei-Überwachungsmoduls (210), um den Betrieb des Dateisystems des Maschinenstation-Servers (100) zu überwachen, und Senden einer Synchronisationsanforderung an das Dateisynchronisationsmodul (220) (S110); und
Steuern des Dateisynchronisationsmoduls (220), um die Synchronisationsanforderung zu empfangen, und Aufrufen eines inkrementellen Sicherungsprogramms, um die Transaktionsdatei zu synchronisieren; und wenn die Synchronisation der Transaktionsdatei abgeschlossen ist, Senden einer Lagerungsanweisung an das Echtzeit-Lagerungsmodul (230), wobei die Lagerungsanweisung verwendet wird, um das Echtzeit-Lagerungsmodul (230) anzuweisen, das Format der Transaktionsdaten gemäß den voreingestellten Lagerungsregeln (S120) zu konvertieren.

3. Maschinenstation-Dateiverarbeitungsverfahren nach Anspruch 1, wobei die Transaktionsdatei mindestens eine Zeile von Transaktionsdaten umfasst; und die Umwandlung eines Formats der Transaktionsdaten gemäß voreingestellter Lagerungsregeln zum Erzeugen von Modellschicht-Daten umfasst:
Festlegen einer ersten Zeile der Transaktionsdaten als festgelegte Zeile (S210);
Lesen der Transaktionsdaten der festgelegten Zeile (S220);
Erfassen von Modellschicht-Daten, die den Transaktionsdaten der festgelegten Zeile entsprechen, gemäß der Transaktionsdatei und den voreingestellten Lagerungsregeln (S230); und
Ausführen einer entsprechenden Lagerungsstrategie gemäß einer Zeilenkennung der festgelegten Zeile (S240).

4. Maschinenstation-Dateiverarbeitungsverfahren nach Anspruch 3, wobei das Ausführen einer entsprechenden Lagerungsstrategie gemäß einem Zeilenidentifikator der festgelegten Zeile (S240) Folgendes umfasst:
wenn die festgelegte Zeile eine letzte Zeile ist, Erzeugen einer Lesekennung für die Transaktionsdatei (S241); und
wenn die festgelegte Zeile nicht die letzte Zeile ist, Festgelegen einer nächsten Zeile der festgelegten Zeile als eine neue festgelegten Zeile (S242) und Wiederholen der Schritte des Lesens der Transaktionsdaten der festgelegten Zeile (S220) und Erfassen von Modellschicht-Daten, die den Transaktionsdaten der festgelegten Zeile entsprechen, gemäß der Transaktionsdatei und den voreingestellten Lagerungsregeln (S230), bis die neue festgelegte Zeile die letzte Zeile wird.

5. Maschinenstation-Dateiverarbeitungsverfahren nach Anspruch 3 oder 4, wobei das Erfassen von Modellschicht-Daten, die den Transaktionsdaten der festgelegten Zeile entsprechen, gemäß der Transaktionsdatei und den voreingestellten Lagerungsregeln (S230) Folgendes umfasst:
Erfassen einer Speicherversion der Transaktionsdatei (S231);
Bestimmen, gemäß der Speicherversion und den vorgegebenen Lagerungsregeln, ob das Format der Bewegungsdaten der festgelegten Zeile konvertiert werden muss (S232);
Konvertieren der Transaktionsdaten der festgelegten Zeile in die Modellschicht-Daten (S233), wenn das Format der Transaktionsdaten der festgelegten Zeile konvertiert werden muss; und
direktes Zurückkehren zum Schritt eines Ausführens einer entsprechenden Lagerhaltungsstrategie gemäß der Zeilenkennung der festgelegten Zeile (S240), wenn das Format der Bewegungsdaten der festgelegten Zeile nicht umgewandelt werden muss.

6. Maschinenstation-Dateiverarbeitungsverfahren nach Anspruch 1, wobei der Überwachungsvorgang eines Dateisystems eines Maschinenstation-Servers (100) Folgendes umfasst: Überwachen von Hinzufügungs- und Änderungsvorgängen des Dateisystems des Maschinenstation-Servers (100) durch Inotify in Linux-Kernel.

7. Maschinenstation-Dateiverarbeitungsverfahren nach Anspruch 1, wobei das Senden, an den Datenlager-Server (300), der Modellschicht-Daten und der Datenanalyseanforderung und der Datenanalyseanforderung verwendet wird, um den Datenlager-Server (300) anzuweisen, Anwendungsschicht-Daten gemäß den Modellschicht-Daten (S300) zu erfassen, Folgendes umfasst:
synchrones Senden der erzeugten Modellschicht-Daten und der Datenanalyseanforderung durch den Edge-Computing-Server (200) an den Datenlager-Server (300) und weiteres Filtern der Modellschicht-Daten durch den Datenlager-Server (300) unter der Anweisung der Datenanalyseanforderung, um in den Anwendungsschichtdaten nur die anzuzeigenden und anzuwendenden Daten zu behalten.

8. Maschinenstation-Dateiverarbeitungsverfahren nach Anspruch 2, wobei das Echtzeit-Lagerungsmodul (230) nach Erfassen der Transaktionsdatei aus einem bestimmten Verzeichnis des Edge-Computing-Servers (200) mit dem Lesen und der Konvertierung von einer ersten Zeile der Transaktionsdaten beginnt, d. h. die erste Zeile der Transaktionsdaten als eine festgelegte Zeile festlegt.

9. Maschinenstation-Dateiverarbeitungsverfahren, das auf ein Maschinenstation-Dateiverarbeitungssystem angewendet wird, **dadurch gekennzeichnet, dass** es einen Datenlager-Server (300) umfasst, wobei das Maschinenstation-Dateiverarbeitungsverfahren Folgendes umfasst: Steuern des Datenlager-Servers (300), zu Folgendem:
Empfangen von Modellschicht-Daten und einer Datenanalyseanforderung, die von einem Edge-Computing-Server (200) gesendet wurde (S400); und
Erfassen eines Datenfeld, das ausgegeben werden soll und Konvertieren eines Formats der Modellschicht-Daten entsprechend dem Datenfeld, um Anwendungsschicht-Daten zu erzeugen, wobei die Anwendungsschicht-Daten zum Erzeugen einer visuellen Seite verwendet werden (S500);
wobei die Modellschicht-Daten durch Konvertieren eines Formats von Transaktionsdaten gemäß voreingestellten Lagerungsregeln erzeugt werden, und die voreingestellten Lagerungsregeln Regeln sind, die für einen Maschinenstation-Server (100) festgelegt wurden und Bedingungen und Verfahren zur Formatkonvertierung der Transaktionsdaten umfassen.

10. Maschinenstation-Dateiverarbeitungsverfahren nach Anspruch 9, wobei das Maschinenstation-Dateiverarbeitungssystem ferner einen Front-End-Anwendungsserver (400) umfasst; und das Maschinenstation-Dateiverarbeitungsverfahren ferner Folgendes umfasst:
Steuern des Datenlager-Servers (300), um die Anwendungsschichtdaten und eine Datenanwendungsanforderung an den Front-End-Anwendungsserver (400) zu senden, wobei die Datenanwendungsanforderung verwendet wird, um den Front-End-Anwendungsserver (400) anzuweisen, eine visuelle Seite gemäß den Anwendungsschichtdaten (S600) zu erfassen; und
Steuern des Front-End-Anwendungsservers (400) zum Empfangen von Anwendungsschichtdaten und einer vom Datenlager-Server (300) gesendeten Datenanwendungsanforderung; Erfassen der visuellen Seite entsprechend den Anwendungsschichtdaten; und Anzeigen der visuellen Seite (S700).

11. Maschinenstation-Dateiverarbeitungsverfahren nach Anspruch 9, wobei das Datenfeld, das ausgegeben werden soll, zuerst erfasst wird, dann die auszugebenden Daten aus den Daten der Modellschicht gefiltert werden und schließlich die Anwendungsschicht-Daten entsprechend den gefilterten Daten erfasst werden.

12. Maschinenstation-Dateiverarbeitungssystem, **dadurch gekennzeichnet, dass** es Folgendes umfasst:
einen Edge-Computing-Server (200), der konfiguriert ist, um den Betrieb eines Dateisystems eines Maschinenstation-Servers (100) zu überwachen und eine von dem Vorgang (S100) erzeugte Transaktionsdatei zu erfassen; ein Format der Transaktionsdaten gemäß voreingestellten Lagerhaltungsregeln zu konvertieren, um Modellschicht-Daten (S200) zu erzeugen; Modellschicht-Daten und einer Datenanalyseanforderung an einen Datenlager-Server (300) zu senden, wobei die Datenanalyseanforderung verwendet wird, um den Datenlager-Server (300) anzuweisen, Anwendungsschicht-Daten gemäß den Modellschicht-Daten (S300) zu erfassen; und
einen Datenlager-Server (300), der konfiguriert ist, um die Modellschicht-Daten und die von einem Edge-Computing-Server (200) gesendete Datenanalyseanforderung zu empfangen(S400); und ein auszugebendes Datenfeld zu erfassen und das Format der Modellschicht-Daten entsprechend dem Datenfeld zu konvertieren, um die Anwendungsschicht-Daten zu erzeugen (S500);
wobei die voreingestellten Lagerungsregeln Regeln sind, die für den Maschinenstation-Server (100) festgelegt wurden, und Bedingungen und Verfahren zur Formatkonvertierung der Transaktionsdaten umfassen.

13. Maschinenstation-Dateiverarbeitungssystem nach Anspruch 12, wobei der Datenlager-Server (300) ferner konfiguriert ist, um die Anwendungsschichtdaten und eine Datenanwendungsanforderung an den Front-End-Anwendungsserver (400) zu senden, wobei die Datenanwendungsanforderung verwendet wird, um den Front-End-Anwendungsserver (400) anzuweisen, eine visuelle Seite gemäß den Anwendungsschichtdaten zu erfassen; und das Maschinenstation-Dateiverarbeitungssystem fernes Folgendes umfasst:
einen Front-End-Anwendungsserver (400), der konfiguriert ist, um die Anwendungsschicht-Daten und die von dem Datenlager-Server (300) gesendete Datenanforderung zu empfangen; eine visuelle Seite entsprechend den Anwendungsschicht-Daten zu erfassen; und die visuelle Seite anzuzeigen.

14. Maschinenstation-Dateiverarbeitungssystem nach Anspruch 12 oder 13, wobei der Edge-Computing-Server (200) Folgendes umfasst:
ein Datei-Überwachungsmodul (210), das konfiguriert ist, um den Betrieb des Dateisystems des Maschinenstation-Servers (100) zu überwachen und eine Synchronisierungsanforderung an ein Dateisynchronisierungsmodul (220) zu senden;
das Dateisynchronisationsmodul (220), das konfiguriert ist, um die Synchronisationsanforderung zu empfangen und ein inkrementelles Sicherungsprogramm auzurufen, um eine Transaktionsdatei zu synchronisieren; und wenn die Synchronisation der Transaktionsdatei abgeschlossen ist, einen Lagerungsbefehl an ein Echtzeit-Lagerungsmodul (230) zu senden, wobei der Lagerungsbefehl verwendet wird, um das Echtzeit-Lagerungsmodul (230) anzuweisen, ein Format der Transaktionsdaten gemäß voreingestellten Lagerungsregeln zu konvertieren; und
das Echtzeit-Warehousing-Modul (230), das konfiguriert ist, um das Format der Transaktionsdaten gemäß voreingestellten Lagerungsregeln zu konvertieren, um Modellschicht-Daten (S200) zu erzeugen; und die Modellschicht-Daten und eine Datenanalyseanforderung an einen Datenlager-Server (300) zu senden, wobei die Datenanalyseanforderung verwendet wird, um den Datenlager-Server (300) anzuweisen, Anwendungsschichtdaten gemäß den Modellschicht-Daten zu erfassen (S300).

## Revendications

1. Procédé de traitement de fichier de machine, appliqué à un serveur informatique périphérique (200), **caractérisé en ce qu'**il comprend les étapes consistant à :
surveiller une opération d'un système de fichier d'un serveur de machine (100) et acquérir un fichier transactionnel généré par l'opération, le fichier transactionnel comprenant des données transactionnelles (S100) ;
convertir un format des données transactionnelles selon des règles d'entreposage prédéfinies pour générer des données de couche de modèle (S200) ; et
envoyer, à un serveur d'entrepôt de données (300), les données de couche de modèle et une demande d'analyse de données, la demande d'analyse de données est utilisée pour donner l'instruction au serveur d'entrepôt de données (300) d'acquérir des données de couche d'application selon les données de couche de modèle (S300) ;
dans lequel, les règles d'entreposage prédéfinies sont des règles qui ont été définies pour le serveur de machine (100), et comprennent des conditions et des procédés pour la conversion de format des données transactionnelles.

2. Procédé de traitement de fichier de machine selon la revendication 1, dans lequel le serveur informatique périphérique (200) comprend un module de surveillance de fichiers (210), un module de synchronisation de fichiers (220) et un module d'entreposage en temps réel (230) ; et la surveillance d'une opération d'un système de fichier d'un serveur de machine (100) et l'acquisition d'un fichier transactionnel généré par l'opération comprennent :
la commande du module de surveillance de fichiers (210) pour surveiller l'opération du système de fichier du serveur de machine (100), et l'envoi d'une demande de synchronisation au module de synchronisation de fichiers (220) (S110) ; et
la commande du module de synchronisation de fichiers (220) pour recevoir la demande de synchronisation, et l'appel d'un programme de sauvegarde incrémentielle pour synchroniser le fichier transactionnel ; et lorsque la synchronisation du fichier transactionnel est terminée, l'envoi d'une instruction d'entreposage au module d'entreposage en temps réel (230), l'instruction d'entreposage étant utilisée pour donner l'instruction au module d'entreposage en temps réel (230) de convertir le format des données transactionnelles selon les règles d'entreposage prédéfinies (S120).

3. Procédé de traitement de fichier de machine selon la revendication 1, dans lequel le fichier transactionnel comprend au moins une ligne de données transactionnelles ; et la conversion d'un format des données transactionnelles selon des règles d'entreposage prédéfinies pour générer des données de couche de modèle comprend :
la définition d'une première ligne des données transactionnelles comme une ligne définie (S210) ;
la lecture des données transactionnelles de la ligne définie (S220) ;
l'acquisition des données de couche de modèle correspondant aux données transactionnelles de la ligne définie selon le fichier transactionnel et les règles d'entreposage prédéfinies (S230) ; et
l'exécution d'une stratégie d'entreposage correspondante en fonction d'un identifiant de ligne de la ligne définie (S240).

4. Procédé de traitement de fichier de machine selon la revendication 3, dans lequel l'exécution d'une stratégie d'entreposage correspondante selon un identifiant de ligne de la ligne définie (S240) comprend :
lorsque la ligne définie est une dernière ligne, la génération d'un identifiant de lecture pour le fichier transactionnel (S241) ; et
lorsque la ligne définie n'est pas la dernière ligne, la définition d'une ligne suivante de la ligne définie comme une nouvelle ligne définie (S242), et la répétition d'étapes de lecture des données transactionnelles de la ligne définie (S220) et l'acquisition de données de couche de modèle correspondant aux données transactionnelles de la ligne définie selon le fichier transactionnel et les règles d'entreposage prédéfinies (S230) jusqu'à ce que la nouvelle ligne définie devienne la dernière ligne.

5. Procédé de traitement de fichier de machine selon la revendication 3 ou 4, dans lequel l'acquisition de données de couche de modèle correspondant aux données transactionnelles de la ligne définie selon le fichier transactionnel et les règles de stockage prédéfinies (S230) comprend :
l'acquisition d'une version de stockage du fichier transactionnel (S231) ;
la détermination, en fonction de la version de stockage et des règles d'entreposage prédéfinies, si le format des données transactionnelles de la ligne définie doit être converti (S232) ;
la conversion des données transactionnelles de la ligne définie en données de couche de modèle (S233), si le format des données transactionnelles de la ligne définie doit être converti ; et
le retour direct à l'étape d'exécution d'une stratégie d'entreposage correspondante selon l'identifiant de ligne de la ligne définie (S240), si le format des données transactionnelles de la ligne définie n'a pas besoin d'être converti.

6. Procédé de traitement de fichiers de machine selon la revendication 1, dans lequel l'opération de surveillance d'un système de fichier d'un serveur de machine (100) comprend : la surveillance des opérations d'ajout et de modification du système de fichier du serveur de machine (100) par Inotify dans le noyau Linux.

7. Procédé de traitement de fichier de machine selon la revendication 1, dans lequel l'envoi, au serveur d'entrepôt de données (300), des données de couche de modèle et de la demande d'analyse de données, et la demande d'analyse de données est utilisée pour donner l'instruction au serveur d'entrepôt de données (300) d'acquérir des données de couche d'application selon les données de couche de modèle (S300) comprend :
l'envoi synchrone, par le serveur informatique périphérique (200), de données de couche de modèle générées et de la demande d'analyse de données au serveur d'entrepôt de données (300), et le filtrage supplémentaire, par le serveur d'entrepôt de données (300), des données de couche de modèle sous l'instruction de la demande d'analyse de données pour retenir, dans les données de couche d'application, uniquement les données à afficher et à appliquer.

8. Procédé de traitement de fichier de machine selon la revendication 2, dans lequel, après avoir acquis le fichier transactionnel à partir d'un répertoire désigné du serveur informatique périphérique (200), le module d'entreposage en temps réel (230) commence la lecture et la conversion à partir d'une première ligne des données transactionnelles, c'est-à-dire qu'il définit la première ligne des données transactionnelles comme une ligne définie.

9. Procédé de traitement de fichier de machine, appliqué à un système de traitement de fichier de machine **caractérisé en ce qu'**il comprend un serveur d'entrepôt de données (300), le procédé de traitement de fichier de machine comprend : la commande du serveur d'entrepôt de données (300) pour :
recevoir des données de couche de modèle et une demande d'analyse de données envoyée par un serveur informatique périphérique (200) (S400) ; et
acquérir un champ de données devant être sorti et convertir un format des données de couche de modèle selon le champ de données pour générer des données de couche d'application, les données de couche d'application étant utilisées pour générer une page visuelle (S500) ;
dans lequel, les données de couche de modèle sont générées en convertissant un format de données transactionnelles selon des règles d'entreposage prédéfinies, et les règles d'entreposage prédéfinies sont des règles qui ont été définies pour un serveur de machine (100), et comprennent des conditions et des procédés pour la conversion de format des données transactionnelles.

10. Procédé de traitement de fichier de machine selon la revendication 9, dans lequel le système de traitement de fichier de machine comprend en outre un serveur d'applications frontales (400) ; et le procédé de traitement de fichier de machine comprend en outre :
la commande du serveur d'entrepôt de données (300) pour envoyer, au serveur d'applications frontales (400), les données de couche d'application et une demande d'application de données, la demande d'application de données est utilisée pour donner l'instruction au serveur d'applications frontales (400) d'acquérir une page visuelle selon les données de couche d'application (S600) ; et
la commande du serveur d'applications frontales (400) pour recevoir des données de couche d'application et une demande d'application de données envoyée par le serveur d'entrepôt de données (300) ; l'acquisition de la page visuelle selon les données de couche d'application ; et l'affichage de la page visuelle (S700).

11. Procédé de traitement de fichier de machine selon la revendication 9, dans lequel le champ de données devant être sorti est acquis en premier, puis les données devant être sorties sont filtrées à partir des données de couche de modèle, et enfin les données de couche d'application sont acquises selon les données filtrées.

12. Système de traitement de fichier de machine, **caractérisé en ce qu'**il comprend :
un serveur informatique périphérique (200), configuré pour surveiller une opération d'un système de fichier d'un serveur de machine (100) et acquérir un fichier transactionnel généré par l'opération (S100) ; convertir un format des données transactionnelles selon des règles d'entreposage prédéfinies, générer des données de couche de modèle (S200) ; et envoyer, à un serveur d'entrepôt de données (300), les données de couche de modèle et une demande d'analyse de données, la demande d'analyse de données est utilisée pour donner l'instruction au serveur d'entrepôt de données (300) d'acquérir des données de couche d'application selon les données de couche de modèle (S300) ; et
un serveur d'entrepôt de données (300), configuré pour recevoir les données de couche de modèle et la demande d'analyse de données envoyée par un serveur informatique périphérique (200) (S400) ; et acquérir un champ de données devant être sorti et convertir le format des données de couche de modèle selon le champ de données pour générer les données de couche d'application (S500) ;
dans lequel, les règles d'entreposage prédéfinies sont des règles qui ont été définies pour le serveur de machine (100), et comprennent des conditions et des procédés pour la conversion de format des données transactionnelles.

13. Système de traitement de fichier de machine selon la revendication 12, dans lequel le serveur d'entrepôt de données (300) est en outre configuré pour envoyer, à un serveur d'applications frontales (400), les données de couche d'application et une demande d'application de données, la demande d'application de données est utilisée pour donner l'instruction au serveur d'applications frontales (400) d'acquérir une page visuelle selon les données de couche d'application ; et le système de traitement de fichier de machine comprend en outre :
un serveur d'applications frontales (400), configuré pour recevoir les données de couche d'application et la demande d'application de données envoyée par le serveur d'entrepôt de données (300) ; acquérir une page visuelle selon les données de la couche d'application ; et afficher la page visuelle.

14. Système de traitement de fichier de machine selon la revendication 12 ou 13, dans lequel le serveur informatique périphérique (200) comprend :
un module de surveillance de fichiers (210) configuré pour surveiller l'opération du système de fichier du serveur de machine (100), et envoyer une demande de synchronisation à un module de synchronisation de fichiers (220) ;
le module de synchronisation de fichiers (220), configuré pour recevoir la demande de synchronisation, et appeler un programme de sauvegarde incrémentielle pour synchroniser un fichier transactionnel ; et lorsque la synchronisation du fichier transactionnel est terminée, envoyer une instruction d'entreposage au module d'entreposage en temps réel (230), l'instruction d'entreposage étant utilisée pour donner l'instruction au module d'entreposage en temps réel (230) de convertir le format des données transactionnelles selon les règles d'entreposage prédéfinies; et
le module d'entreposage en temps réel (230), configuré pour convertir le format des données transactionnelles selon les règles d'entreposage prédéfinies pour générer des données de couche de modèle (S200) ; et envoyer, à un serveur d'entrepôt de données (300), les données de couche de modèle et une demande d'analyse de données, la demande d'analyse de données est utilisée pour donner l'instruction au serveur d'entrepôt de données (300) d'acquérir des données de couche d'application selon les données de couche de modèle (S300).
